Europäisches Patentamt

European Patent Office

Office européen des brevets

(19)

(11) Publication number : **0 308 892 B1**

(12) **EUROPEAN PATENT SPECIFICATION**

(45) Date of publication of patent specification :
26.04.95 Bulletin 95/17

(51) Int. Cl.⁶ : **H01L 39/24, H01L 39/12**

(21) Application number : 88115471.0

(22) Date of filing : 21.09.88

(54) **Flaky oxide superconductor and method of manufacturing the same.**

(30) Priority : 21.09.87 JP 236608/87
27.07.88 JP 187555/88

(43) Date of publication of application :
29.03.89 Bulletin 89/13

(45) Publication of the grant of the patent :
26.04.95 Bulletin 95/17

(84) Designated Contracting States :
DE GB

(56) References cited :
JAPANESE JOURNAL OF APPLIED PHYSICS,
vol. 26, no. 5, part 2, May 1987, pages
L812-L814, Tokyo, JP; S. OHSHIMA et al.:
"Preparation and superconducting properties
of the Ba1-xYx-CuO3-y compounds"
IEEE SPECTRUM, vol. 25, no. 5, May 1988,
pages 30-41, New York, US; K. FITZGERALD:
"Superconductivity: fact VS. Fancy"
JAPANESE JOURNAL OF APPLIED PHYSICS,
vol. 26, no. 5, May 1987, pages L754-L756,
Tokyo, JP; M. KOBAYASHI et al.: "High Tc
superconductivity of Y-Ba-Cu-O ceramics"
Jap. J. Appl. Phys., vol. 26, no. 5, May 1987, pp.
L678-L681, T. Nakamura and R. Liang
Z. Phys. B - Condensed Matter 66, (1987), pp.
141-146, C. Politis et al.
Appl. Phys. Lett. 51 (7), August 1987, pp.
538-539, R. Haldar et al.
Halbleiterepitaxie, H.G. Schneider, (1984), Dr.
Alfred Hüthig, Verlag Heidelberg, pp. 168-169.
Jap. J. Appl. Phys., vol. 26, no. 5, May 1987, pp.
L851-L853, S. Takekawa and N. Iyi
Nature, vol. 328, August 1987, pp. 601-603, L.F.
Schneemeyer et al.
Jap. J. Appl. Phys., vol. 26, no. 8, August 1987,
pp. L1421-1423, M. Omori et al.

(73) Proprietor : **THE FURUKAWA ELECTRIC CO.,
LTD.**
**6-1, 2-chome, Marunouchi**
**Chiyoda-ku**
**Tokyo (JP)**

(72) Inventor : **Kikuchi, Hiroyuki**
**34-5, Miyagaya**
**Nishi-ku**
**Yokohama-shi (JP)**
Inventor : **Shiroyama, Kaisuke**
**4105-8 Kurihara**
**Zama-shi Kanagawa-ken (JP)**
Inventor : **Mashimo, Keiji**
**211 Ooguchinaka-machi**
**Kanagawa-ku**
**Yokohama-shi (JP)**
Inventor : **Tanaka, Yasuzo**
**8-6, Takinoue**
**Naka-ku**
**Yokohama-shi (JP)**
Inventor : **Uno, Naoki**
**2-6-508, Mitsuzawanishi-cho**
**Kanagawa-ku Yokohama-shi (JP)**
Inventor : **Shiga, Shoji**
**771-2, Shukugo-cho**
**Utsunomiya-shi Tochigi-ken (JP)**

(74) Representative : **Kolb, Helga, Dr. Dipl.-Chem.
et al**
**Hoffmann, Eitle & Partner,**
**Patentanwälte,**
**Postfach 81 04 20**
**D-81904 München (DE)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 308 892 B1

## Description

The present invention relates to an oxide superconductor powder used in the manufacture of a superconductor shaped body or a strip and a method of manufacturing the same and, more particularly, to an oriented flaky oxide superconductor powder and a method of manufacturing the same.

An oxide superconductor such as a Y-Ba-Cu-O, La-Sr-Cu-O, or Bi-Sr-Ca-Cu-O oxide superconductor is known as a material having a superconducting state at a relatively high temperature.

In a method of manufacturing an oxide superconductor (strip) consisting of a rare earth element or Bi, an alkaline earth metal, Cu, and oxygen, primary starting materials such as an oxide or carbonate containing elements constituting an oxide superconductor are prepared and mixed to have a desired composition. The prepared composition is calcined and then pulverized. The resultant powder is a massive powder which is then molded. The shaped body is heat-treated to obtain an oxide superconductor shaped body.

In a method of preparing a strip according to calcination and pulverization, a metal pipe is filled with a calcined and pulverized powder, and the resultant structure is subjected to plastic working such as drawing, extrusion, rolling, and swaging to prepare a composite wire having a desired shape and desired dimensions. Thereafter, the composite wire is heat-treated in an oxygen-containing atmosphere.

In another conventional method, a calcined and pulverized powder is compression-molded, and the shaped body is heat-treated in an oxygen-containing atmosphere to obtain a bulk body.

Such an oxide superconductor has a laminar perovskite crystal structure. This crystal structure has a direction along which a current tends to flow and a direction along which a current tends not to flow. More specifically, a current tends to flow in the a- and b-axis planes, but not in the c-axis direction.

The superconducting characteristics have similar anisotropy. Critical current densities in the a- and b-axis planes are much larger than the critical current density in the c-axis direction. An oxide superconductor powder manufactured by the above method has an isotropic crystal structure. Therefore, its critical current density is smaller than those in the a- and b-axis planes of the crystal. The document Z. Phys. B - Condensed Matter 66, (1987), pp. 141-146, C. Politis et al., discloses the preparation of an oxide superconductor by heating between 900°C and 1100°C and quenching. The necessity of cooling rates of $T \geqq 100$ K/s is mentioned.

The document Jap. J. of Appl. Phys., vol. 26, no. 8, August 1987, pp. L1421-L1423, M. Omori et al., discloses the preparation of orientented orthorhombic polycrystals from tetragonal plate-like crystals of an oxide superconductor.

The present invention has been made in consideration of the above situation, and, as its object, provides two methods of manufacturing an oxide superconductor having a large critical current density.

Since a crystal orientation of a calcined powder of a precursor of an oxide superconductor prepared by the conventional method is random, the shaped body obtained by compression-molding the calcined powder cannot have a high critical current density (Jc).

It is an object of the present invention to provide two methods of manufacturing a flaky oxide superconductor whose crystal orientation can be controlled in a conventional oxide superconductor manufacturing method (solid-phase method) consisting of powder molding and a heat treatment.

An oxide superconductor consisting of a rare earth element or Bi, an alkaline earth metal, copper, and oxygen has a flaky outer appearance and a laminar crystal structure. The direction of thickness of the superconductor coincides with the c-axis direction of the crystal.

The flaky oxide superconductor described above can be manufactured by the following two methods (methods A and B). Method A is as set forth in claim 1.

Alternatively, method B is set forth in claim 4.

This invention can be more fully understood from the following detailed description when taken in conjunction with the accompanying drawings, in which:

Figs. 1A and 1B are views for explaining a superconductor layer consisting of a flaky oxide superconductor according to the present invention;

Figs. 1C and 1D are views for explaining a superconductor layer consisting of a conventional massive oxide superconductor;

Fig. 2 is a view for explaining a crystal structure of a plate-like superconductor obtained by rapid solidification in an intermediate process of the present invention;

Fig. 3 is a view for explaining a method of manufacturing a flaky oxide superconductor according to one directional solidification; and

Fig. 4 is a graph showing a temperature gradient in an electric furnace.

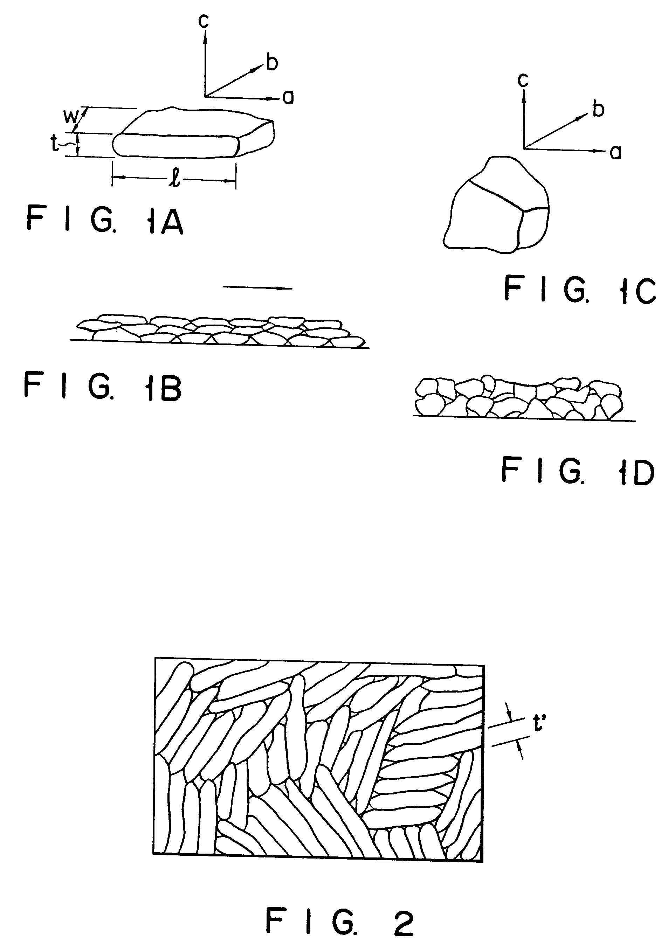

As shown in Fig. 1A, a flaky oxide superconductor according to the present invention has a flaky structure, the c-axis in a direction of thickness (t), and the a- and b-axis in its surface. As shown in Fig. 1A, $\ell$ and W denote a length and a width of a flake. When the flaky oxide superconductor is arranged on an underlying sur-

2

face, the flaky surface can be parallel to the underlying surface, so that powder grains are arranged in the form of layers each having a thickness of $t$, as shown in Fig. 1B. When a current is supplied to the superconductor in a direction parallel to the underlying surface (the arrow in Fig. 1B indicates the direction of current flow), a current flow within the plane is defined by the a- and b-axis of the superconductor. When a superconductor layer is formed by such a flaky oxide superconductor, crystal orientation can be easily controlled. Therefore, the critical current density can be increased.

As a comparison, when a superconductor layer is made of the conventional massive powder shown in Fig. 1C, the a- and b-axis having large critical current densities are not aligned in one direction and are isotropic, as shown in Fig. 1D. Therefore, the critical current density of the superconductor layer is lower than that of the superconductor layer made of the powder of the present invention.

A method of manufacturing a flaky oxide superconductor according to the present invention will be described below (method A).

A material powder having, e.g., a composition of $YBa_2Cu_3O_{7-y}$ is prepared by mixing material oxide powders such as $Y_2O_3$, $BaCO_3$, $CuO$, and the like to have a desired composition. The material mixture powder is powder-molded. Alternatively, the powder is heat-treated in an oxygen atmosphere at 500 to 1,000°C and is thus softened or melted. The softened or melted material is rapidly solidified at a rate of $10^2$°C/S to $10^4$°C/S.

When the material mixture powder is used without any treatment or after powder molding, the softened or melted material is subjected to decomposition of CuO into Cu and O. It is therefore preferable to preheat the material mixture powder. The preheating temperature falls within the range of 500 to 1,000°C due to the following reason. If the temperature is less than 500°C, the CuO powder is excessively left to accelerate the decomposition as described above. If the temperature exceeds 1,000°C, the total amount of oxygen loss is increased. Rapid cooling and solidification may be performed such that a material is flowed on, e.g., a metal plate, or that a material is rapidly cooled between two metal plates. Rapid liquid cooling using a single or double roller may be used. However, if the rate of solidification is $10^2$°C/S or less, a long period of time is required for the subsequent heat treatment. On the other hand, it is difficult to set the rate of solidification to be $10^4$°C/S or more. Therefore, the rate of solidification preferably falls within the range of $10^2$ to $10^4$°C/S.

The resultant solidified material (plate-like material) obtained by rapid cooling is heat-treated in an oxygen atmosphere. The temperature of the heat treatment falls within the range of 500 to 1,000°C. In this case, a rate of decrease in temperature after the heat treatment is preferably small. As a result, an oxide material having a flaky crystal structure shown in Fig. 1A can be obtained, as shown in Fig. 2. Thickness $t'$ of the crystal grain of this oxide material is substantially equal to thickness $t$ of the flake. Thickness $t'$ of the crystal grain is changed by a heat-treatment temperature and time after solidification by rapid cooling. For example, when a heat treatment is performed in an oxygen atmosphere at 900°C, the thickness is set to be 1 to 2 $\mu$ upon a heat-treatment time of about 10 hours; 3 to 4 $\mu$ upon about 20 to 30 hours; 5 to 6 $\mu$ upon about 30 to 40 hours; and 10 to 13 $\mu$ upon 60 to 70 hours.

The above oxide material is pulverized to prepare a flaky oxide superconductor having a large orientation, as shown in Fig. 1A. In this case, if the oxide material is small in amount, a mortar may be used. However, a ball mill or high-energy attritor may also be used.

Another method of manufacturing a flaky oxide superconductor according to the present invention will be described below (method B).

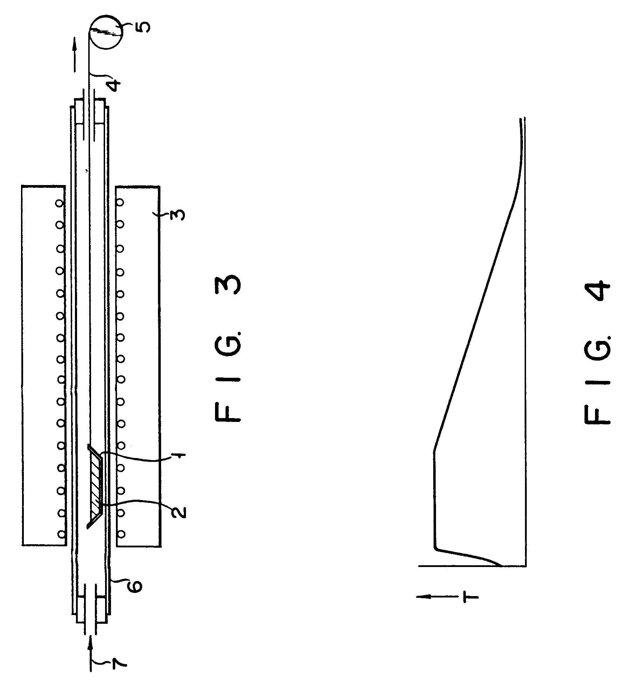

Fig. 3 shows a case in which a material is cooled and solidified in one direction. Starting material 2 containing elements constituting the oxide superconductor having a desired composition is placed on a boat 1 inserted in a quartz pipe 6 and is heated and melted in electric furnace 3. If starting material 2 is a Y-based material, it is semi-melted at a temperature of 950 to 1,200°C and is melted at 1,200°C or more. However, if the temperature is excessively high, the material is strongly reacted with the constituting material of boat 1. Therefore, the reaction temperature is preferably 1,500°C or less. When material 2 is heated to a predetermined temperature for the semi-molten or molten state, strip 4 is wound around drum 5, and boat 1 is moved to the right, as indicated by an arrow in Fig. 3.

In this case, a calcined material is used as starting material 2.

Boat 1 is preferably made of a material such as Pt or a Pt alloy which is less reacted with the starting material.

It is preferable that the moving speed of boat 1 is arbitrarily controlled or to be about several tens of microns/S. In this case, the interior of electric furnace 3 has a temperature gradient shown in Fig. 4 (the minimum value of temperature (T) along the ordinate represents room temperature). When boat 1 is moved to the right, molten material 2 is cooled and solidified from the take-up side in one direction. When the molten material is cooled to the other end, it has a crystal structure elongated in the longitudinal direction. Each crystal grain is a flaky grain whose length is defined by the a-b plane and the direction of thickness is defined in the c-axis.

The resultant material is heated at a relatively low temperature (500 to 1000°C) in an oxygen-containing atmosphere formed by supplying oxygen gas 7, and is then pulverized to prepare an oriented flaky oxide superconductor. When cooling and solidification in one direction are performed in the oxygen-containing atmosphere, a subsequent heat treatment need not be performed to obtain a flaky oxide superconductor.

Heating need not be performed using an electric furnace. Radiofrequency induction heating, infrared heating or the like may be utilized in place of heating with an electric furnace.

In order to manufacture a $YBa_2Cu_3O_{7-y}$ superconductor, it is preferable to include a slightly larger amount of Cu or Cu and Ba in the composition of the starting material due to the following reason. If Y : Ba : Cu is 1 : 2 : 3 (molor ratio), a heterogeneous phase ($Y_2BaCuO_5$) is produced in cooling and solidification to degrade the properties of the oxide superconductor.

Starting material 2 of the oxide superconductor according to the present invention is not limited to a Y-based material, but may be extended to a Bi-Sr-Ca-Cu-O material or T1-based material.

Example 1

$Y_2O_3$, $BaCO_3$, and CuO powders were mixed to prepare a powder mixture having a composition of $YBa_2Cu_3O_{7-y}$. The resultant powder mixture was heat-treated in an oxygen atmosphere at 900°C for 5 hours. The heat-treated material was heated, softened, or melted in a melting pot. The softened or melted material was rapidly cooled at different rates of solidification from a predetermined temperature. The rapidly cooled material was heat-treated in a 950°C atmosphere for various lengths of time. The heat-treated material was pulverized in a ball mill. Results including the dimensions of the resultant flaky products are summarized in Table 1. X-ray diffraction (Fig. 1A) indicated that the flaky products according to the present invention had a structure in which the direction of thickness (t) coincides with the c-axis. As a comparative example, a structure shown in Fig. 1A could not be obtained even if the heat-treatment time was prolonged. As a result, products of the comparative example were not flaky powders but massive powders as shown in Fig. 1C.

Table 1

| | Softening or Melting Temperature by Heating (°C) | Rate of Rapid Solidification (°C/S) | Heat Treatment Time (hr) | Flake | |
| --- | --- | --- | --- | --- | --- |
| | | | | Thickness ($\mu$) | Length ($\mu$) | |
| Example 1 | 1000 | $5 \times 10^2$ | 20 | 3 | 6.5 | |
| | 1300 | $10^3$ | 30 | 3.7 | 9.0 | |
| | 1400 | $10^2$ | 40 | 5.2 | 10.5 | |
| | 1400 | $10^3$ | 10 | 1.2 | 5.5 | |
| | 1400 | $10^3$ | 30 | 4.0 | 9.0 | |
| | 1400 | $10^3$ | 60 | 12.5 | 20.0 | |
| Comparative Example | 1400 | 70 | 30 | – | – | No flake formed |
| | 1400 | 70 | 60 | – | – | |

Flakes (Table 1) each having a thickness of 5.2 $\mu$ and a length of 10.5 $\mu$ obtained in Example 1 were kneaded with a binder and the material so obtained was coated on a surface of an Ag rod having an outer diameter of 10 mm to form a film having a thickness of about 100 $\mu$. The binder was then removed (i.e., heating at 150°C for an hour), and an Ag pipe having an outer diameter of 15 mm and an inner diameter of 11 mm was covered on the film to obtain a double pipe structure. The diameter of the resultant structure was reduced to an outer diameter of 1 mm. Subsequently, the resultant structure was heated in an oxygen flow at 850°C for about 20 hours, and the properties of the heated structure were measured. Critical temperature Tc = 91 K and critical current density Jc = 10,300 A/cm² (liquid nitrogen (LN₂), 0 GaUSS (0 G)) were obtained. For the purpose of comparison, a nonoriented conventional calcined powder (grain size of 5 $\mu$) was used and a product was prepared following the same procedures as in Example 1. Tc = 87 K and Jc = 400 A/cm² were obtained with this product, which were lower than those obtained with the flakes prepared in the present invention.

Example 2

$Bi_2O_3$, $SrCO_3$, $CaCO_3$, and CuO powders were weighed and mixed to obtain a ratio of Bi : Sr : Ca : Cu = 2 : 2 : 2 : 3. The resultant mixture was calcined in air at 820°C for 5 hours. The calcined material was heated in a platinum melting pot and was softened or melted. The softened or melted material was rapidly cooled at several cooling rates. The resultant cooled products (plate-like products) were heated in air at 870°C for various lengths of time and were pulverized in a ball mill for an hour. Results of Example 2 and a comparative example are summarized in Table 2.

Table 2

| | Soften-ing or Melting Temper-ature by Heating (°C) | Rate of Rapid Solidi-fication (°C/S) | Heat Treat-ment Time (hr) | Flake | | |
| --- | --- | --- | --- | --- | --- | --- |
| | | | | Thickness (μ) | Length (μ) | |
| Example 2 | 950 | 500 | 30 | 5.7 | 12.2 | |
| | 1200 | $10^2$ | 20 | 5.0 | 11.5 | |
| | 1200 | $10^3$ | 30 | 7.8 | 15.9 | |
| | 1200 | $10^3$ | 60 | 15.1 | 31.6 | |
| Compa-rative Example | 1200 | 70 | 30 | – | – | No flake formed |
| | 1200 | 70 | 60 | – | – | |

X-ray diffraction revealed that the flake prepared according to the present invention had a crystal structure in which a current easily flows along the longitudinal direction of the flake.

The flakes each having a thickness of 7.8 μ and a length of 15.9 μ in Table 2 were filled in an Ag pipe having an outer diameter of 10 mm and an inner diameter of 5 mm, and the pipe was subjected to areal reduction to an outer diameter of 0.4 mm. Subsequently, the area-reduced pipe was heat-treated in an $O_2$ flow at 850°C for 4 hours. The properties of the wire were measured to be Tc = 98 K and Jc = 1,570 A/cm² (LN₂, O G).

For a comparison, $Bi_2O_3$, $SrCO_3$, $CaCO_3$, and CuO powders were weighed and mixed to obtain a ratio of Bi : Sr : Ca : Cu = 2 : 2 : 2 : 3, and the resultant mixture was calcined in air at 820°C for 5 hours. A product was obtained following the same procedures as in Example 2, and its properties were measured to be Tc = 87 K and Jc = 110 A/cm² which were lower than those of the flakes of the present invention.

Example 3

$Y_2O_3$, $BaCO_3$, and CuO powders were weighed and mixed in a ratio of Y : Ba : Cu = 1 : 2 : 3.5 (molor ratio). The resultant mixture was calcined in an $O_2$ flow (4 liters/min) at 920°C for 20 hours. The calcined material was heated and melted by the method shown in Fig. 3 and was cooled and solidified in one direction. In this case, boat 1 was a Pt boat having dimensions of 10 mm (width) × 5 mm (depth) × 50 mm (length) and solidification was performed in an $O_2$ flow (4 liters/min). A moving speed of boat 1 was 100 μ/S, and a temperature gradient was 100°C/cm. The resultant bulk body was removed from the furnace and pulverized in an automatic mortar for 15 minutes. As a result, a flaky oxide superconductor had a thickness of about 20 μ and a length of 100 to 300 μ.

The resultant flaky oxide superconductor was analyzed according to X-ray diffraction, and the direction of its thickness was confirmed to coincide with the c-axis of the crystal. A starting material as in the composition described above was cooled and solidified from semi-molten states of 950°C, 1,050°C, and 1,150°C in one direction, or from molten states of 1,250°C and 1,350°C. In either case, substantially the same results were obtained.

An Ag pipe having an outer diameter of 10 mm and an inner diameter of 5 mm, was filled with this flaky oxide superconductor, and swaging and rolling with a fluted roll were performed to prepare a composite wire having an outer diameter of 0.4 mm. Thereafter, the composite wire was heated in an $O_2$ flow (4 liters/min) at 850°C for four hours and was gradually cooled at a rate of 2°C/min. Critical current density Jc of the resultant superconductor wire was measured to be 18,500 A/cm² (LN₂, 0 G).

As a comparison, the calcined powder was filled in an Ag pipe as in the case described above to prepare a composite wire. The composite wire was heated, and its critical current density Jc was as low as 1,500 A/cm² (LN₂, 0 G).

Example 4

$Bi_2O_3$, $SrCO_3$, $CaCO_3$, and CuO powders were weighed and mixed to obtain a ratio of Bi : Sr : Ca : Cu = 2 : 2 : 2 : 3, and the resultant mixture was calcined in air at 820°C for 5 hours.

The calcined powder was placed in a Pt boat having dimensions of 10 mm (width) x 5 mm (depth) x 50 mm (length) and was Solidified in one direction. A highest temperature was 1,000°C , a temperature gradient was 50°C /cm, and a moving speed was 100 μ m/S. Solidification was performed in an oxygen flow. The resultant bulk body was removed and pulverized in an automatic mortar for 15 minutes to prepare a flaky oxide superconductor having a maximum thickness of 16 μ and a length of 36 to 100 μ . An Ag pipe having an outer diameter of 10 mm and an inner diameter of 5 mm was filled with the superconductor so made following the same procedures as described above. The pipe was then cold-worked and was heated in an oxygen flow at 850°C for 4 hours. The properties of the resultant product were evaluated to be Tc = 95 K and Jc = 1,460 (A/cm²) (LN₂, 0 G). As compared with the conventional calcined powder, with the use of the flakes of the present invention, an oxide superconductor wire having excellent characteristics can be apparently obtained.

For a comparison, $Bi_2O_3$, $SrCO_3$, $CaCO_3$, and CuO powders were weighed and mixed to obtain a ratio of Bi : Sr : Ca : Cu = 2 : 2 : 2 : 3, and the resultant mixture was calcined in air at 820°C for 5 hours. A product was obtained following the same procedures as in Example 2, and its properties were measured to be Tc = 87 K and Jc = 110 A/cm² which were lower than those of the flakes of the present invention.

According to the manufacturing method of the present invention, an axially-oriented flaky oxide superconductor having a c-axis coinciding with the direction of thickness and a large critical current density is obtained. This superconductor can be worked into various forms such as wires or thick films with improved critical current densities (Jc). Therefore, the present invention provides a great industrial advantage.

**Claims**

1. A method of manufacturing a flake of oxide superconductor comprising the steps of:
mixing oxide material powders for an oxide superconductor consisting of a rare earth element or Bi, an alkaline earth metal, copper, and oxygen and having a desired composition;
heating the powder mixture to either melt it or to soften it to a semi-molten state;
rapidly cooling the softened or melted powder mixture at a rate of cooling of $10^2$°C/s to $10^4$°C/s;
heat-treating the material formed in the rapid cooling step in an oxygen atmosphere at a temperature of 500-1,000°C; and
pulverizing the heat-treated material into flakes.

2. A method according to claim 1, characterized in that the oxide powders are $Y_2O_3$, $BaCO_3$, and CuO and are mixed to have a composition of Y-$Ba_2$-$Cu_3$-$O_{7-y}$.

3. A method according to claim 1, characterized in that the oxide powders are $Bi_2O_3$, $SrCO_3$, $CaCO_3$, and CuO, and are mixed to obtain a ratio of Bi : Sr : Ca : Cu of 2 : 2 : 2 : 3.

4. A method of manufacturing a flake of oxide superconductor comprising the steps of:
(i) mixing oxide material powders for an oxide superconductor consisting of a rare earth element or Bi, an alkaline earth metal, copper, and oxygen and having a desired composition;
(ii) heating the powder oxide mixture to a molten or semi-molten state;
(iii) cooling and solidifying a body of the heated oxide mixture in one direction commencing at one end of the body and continuing along its longitudinal direction to its other end by moving the body relative to a temperature gradient so that said cooling and solidifying take place along the direction of movement and at a cooling rate of 1°C/s;
(iv) if step (iii) is not carried out in an oxygen-containing atmosphere, then heat treating the cooled and solidified oxide mixture in an oxygen-containing atmosphere at 500-1,000°C; and
(v) pulverizing the cooled and solidified superconductor oxide mixture into flakes.

**5.** A method according to claim 4, characterized in that the oxide powder consists of $Y_2O_3$, $BaCO_3$, and $CuO$ and is mixed to have a composition of $Y\text{-}Ba_2\text{-}Cu_3\text{-}O_{7-y}$.

**6.** A method according to claim 4, characterized in that the oxide powder consists of $Bi_2O_3$, $SrCO_3$, $CaCO_3$, and $CuO$, and is mixed to obtain a ratio of Bi : Sr : Ca : Cu of 2 : 2 : 2 : 3.

## Patentansprüche

**1.** Verfahren zur Herstellung einer Schuppe aus Oxidsupraleiter, umfassend die Schritte:
Mischen von Oxidmaterialpulvern für einen Oxidsupraleiter, bestehend aus einem Seltenerdelement oder Bi, einem Erdalkalimetall, Kupfer und Sauerstoff und mit einer gewünschten Zusammensetzung;
Erhitzen der Pulvermischung, entweder um sie zu schmelzen oder sie zu einem halbgeschmolzenen Zustand zu erweichen;
schnelles Kühlen der erweichten oder geschmolzenen Pulvermischung bei einer Kühlrate von $10^2$°C/s bis $10^4$°C/s;
Wärmebehandeln des in dem schnellen Kühlschritt gebildeten Materials in einer Sauerstoffatmosphäre bei einer Temperatur von 500 bis 1000°C; und
Pulverisieren des wärmebehandelten Materials zu Schuppen.

**2.** Verfahren nach Anspruch 1,
dadurch **gekennzeichnet**, daß
die Oxidpulver $Y_2O_3$, $BaCO_3$ und $CuO$ sind, und daß sie vermischt werden, unter Erhalt einer Zusammensetzung von $Y\text{-}Ba_2\text{-}Cu_3\text{-}O_{7-y}$

**3.** Verfahren nach Anspruch 1,
dadurch **gekennzeichnet**, daß
die Oxidpulver $Bi_2O_3$, $SrCO_3$, $CaCO_3$, und $CuO$ sind und daß sie vermischt werden, unter Erhalt eines Verhältnisses von Bi : Sr : Ca : Cu von 2:2:2:3.

**4.** Verfahren zur Herstellung einer Schuppe aus Oxidsupraleiter, umfassend die Schritte:
(i) Mischen von Oxidmaterialpulvern für einen Oxidsupraleiter, bestehend aus einem Seltenerdelement oder Bi, einem Erdalkalimetall, Kupfer und Sauerstoff, und mit einer gewünschten Zusammensetzung;
(ii) Erhitzen der Pulveroxidmischung zu einem geschmolzenen oder halbgeschmolzenen Zustand;
(iii) Kühlen und Verfestigen eines Körpers der erhitzen Oxidmischung in einer Richtung, beginnend an einem Ende des Körpers und weiterführend entlang seiner longitudinalen Richtung zu einem anderen Ende durch Bewegen des Körpers relativ zu einem Temperaturgradienten, so daß das Kühlen und Verfestigen entlang der Bewegungsrichtung und bei einer Kühlrate von 1°C/s stattfinden;
(iv) wenn Schritt (iii) nicht in einer sauerstoffhaltigen Atmosphäre durchgeführt wird, anschließendes Wärmebehandeln der gekühlten verfestigten Oxidmischung in einer sauerstoffhaltigen Atmosphäre bei 500 bis 1000°C; und
(v) Pulverisieren der gekühlten und verfestigten Supraleiteroxidmischung zu Schuppen.

**5.** Verfahren nach Anspruch 4,
dadurch **gekennzeichnet**, daß
das Oxidpulver aus $Y_2O_3$, $BaCO_3$, und $CuO$ besteht und vermischt wird, unter Erhalt einer Zusammensetzung von $Y\text{-}Ba_2\text{-}Cu_3\text{-}O_{7-y}$.

**6.** Verfahren nach Anspruch 4,
dadurch **gekennzeichnet**, daß
das Oxidpulver aus $Bi_2O_3$, $SrCO_3$, $CaCO_3$ und $CuO$ besteht und vermischt wird, unter Erhalt eines Verhältnisses von Bi:Sr:Ca:Cu von 2:2:2:3.

## Revendications

**1.** Procédé de fabrication d'une paillette de supraconducteur en oxyde comprenant les étapes consistant à :
- mélanger des poudres de matières en oxydes pour un supraconducteur en oxyde constituées d'un élément des terres rares ou de Bi, d'un métal alcalino-terreux, de cuivre, et d'oxygène, et ayant une composition désirée;
- chauffer le mélange de poudres soit pour le fondre, soit pour le ramollir jusqu'à l'état semi-fondu;
- refroidir rapidement le mélange de poudres ramolli ou fondu à une vitesse de refroidissement de $10^2\,°C/s$-$10^4\,°C/s$;
- traiter thermiquement le matériau formé dans l'étape de refroidissement rapide dans une atmosphère d'oxygène à une température de 500-1 000°C; et
- pulvériser le matériau traité thermiquement pour obtenir des paillettes.

2. Procédé selon la revendication 1, caractérisé en ce que les poudres d'oxydes sont $Y_2O_3$, $BaCO_3$ et CuO et sont mélangées pour avoir la composition $Y$-$Ba_2$-$Cu_3$-$O_{7-y}$.

3. Procédé selon la revendication 1, caractérisé en ce que les poudres d'oxydes sont $Bi_2O_3$, $SrCO_3$, $CaCO_3$ et CuO et sont mélangées pour obtenir un rapport Bi : Sr : Ca : Cu de 2 : 2 : 2 : 3.

4. Procédé de fabrication d'une paillette de supraconducteur en oxyde, comprenant les étapes consistant à :
(i) mélanger des poudres de matières en oxydes pour un supraconducteur en oxyde constituées d'un élément des terres rares ou de Bi, d'un métal alcalino-terreux, de cuivre, et d'oxygène, et ayant une composition désirée;
(ii) chauffer le mélange d'oxydes en poudre à l'état fondu ou semi-fondu;
(iii) refroidir et solidifier un corps du mélange chauffé d'oxydes dans une direction commençant à une extrémité du corps et se poursuivant suivant son sens longitudinal jusqu'à son autre extrémité en déplaçant le corps par rapport à un gradient de température de façon que lesdits refroidissement et solidification aient lieu dans le sens de déplacement, et à une vitesse de refroidissement de 1°C/s;
(iv) si l'étape (iii) n'est pas exécutée dans une atmosphère contenant de l'oxygène, traiter alors thermiquement le mélange d'oxydes refroidi et solidifié dans une atmosphère contenant de l'oxygène à 500-1 000°C; et
(v) pulvériser le mélange d'oxydes supraconducteur refroidi et solidifié pour obtenir des paillettes.

5. Procédé selon la revendication 4, caractérisé en ce que la poudre d'oxydes est constituée de $Y_2O_3$, $BaCO_3$ et CuO et est mélangée de manière à avoir la composition $Y$-$Ba_2$-$Cu_3$-$O_{7-y}$.

6. Procédé selon la revendication 4, caractérisé en ce que la poudre d'oxydes est constituée de $Bi_2O_3$, $SrCO_3$, $CaCO_3$ et CuO, et est mélangée de manière à obtenir le rapport entre Bi : Sr : Ca : Cu de 2 : 2 : 2 : 3.

F I G. 1A

F I G. 1C

F I G. 1B

F I G. 1D

F I G. 2

F I G. 3

F I G. 4